# EUROPEAN PATENT SPECIFICATION

(11) **EP 2 479 781 B1**
(45) Date of publication and mention of the grant of the patent: **14.05.2014**
(21) Application number: 10816963.2
(22) Date of filing: 16.07.2010
(51) Int. Cl.: H01L 21/3065, H05H 1/46, H01J 37/32

(54) **PLASMA ETCHING METHOD**
PLASMAÄTZVERFAHREN
PROCÉDÉ DE GRAVURE AU PLASMA

(30) Priority: 15.09.2009 JP 2009212727
(43) Date of publication of application: 25.07.2012
(73) Proprietor: SPP Technologies Co., Ltd., Chiyoda-ku, Tokyo 1000-0004 (JP)
(72) Inventor: YAMAMOTO, Takashi, Amagasaki-shi Hyogo 660-0891 (JP); IKEMOTO, Naoya, Amagasaki-shi Hyogo 660-0891 (JP)
(74) Representative: Isarpatent
(86) International application number: PCT/JP2010/062035
(87) International publication number: WO 2011/033850

(56) References cited:
- EP-A1- 1 287 548
- WO-A1-00/36631
- WO-A2-2009/104919
- JP-A- 8 186 095
- US-B1- 6 352 049

## Description

### Technical Field

The present invention relates to a plasma etching method in which a processing gas including an etching gas is excited into a plasma and a substrate to be processed is etched by the processing gas excited into a plasma.

From US 6 352 049 B1 an apparatus and a method for plasma assisted processing of a workpiece is known, which provides for separate control of species density within a processing plasma. The apparatus has a processing chamber and at least one collateral chamber, in between which filters may be interposed.

In WO 00/36631 A1 a plasma processing apparatus with a dielectric window, an antenna and a series of parallel tubes with magnets is described, such that the number of ions reaching the substrate is decreased while the number of radicals is unchanged.

From EP 1 287 548 A1 plasma etching equipment is known with an etching chamber consisting of two connected parts, each with its own plasma generating area and high-frequency electromagnetic alternative field generator, where the first part of the etching chamber is directly connected to a gas supply and the second part of the etching chamber is connected to that gas supply only through the first part.

From WO 2009/104919 A2 a plasma etching apparatus is known with a creation space where radicals are created and a process space where a process is carried out with respect to a substrate, configured such that both spaces have separate gas supplies and are connected via a multitude of spray holes through an otherwise dividing spray plate.

### Background Art

As such a plasma etching apparatus, conventionally, an apparatus as shown in Fig. 7 (refer to the Japanese Unexamined Patent Application Publication No. 2006-54305) and an apparatus as shown in Fig. 8 (refer to the Japanese Unexamined Patent Application Publication (Translation of PCT Application) No. 2003-533878) are known, for example.

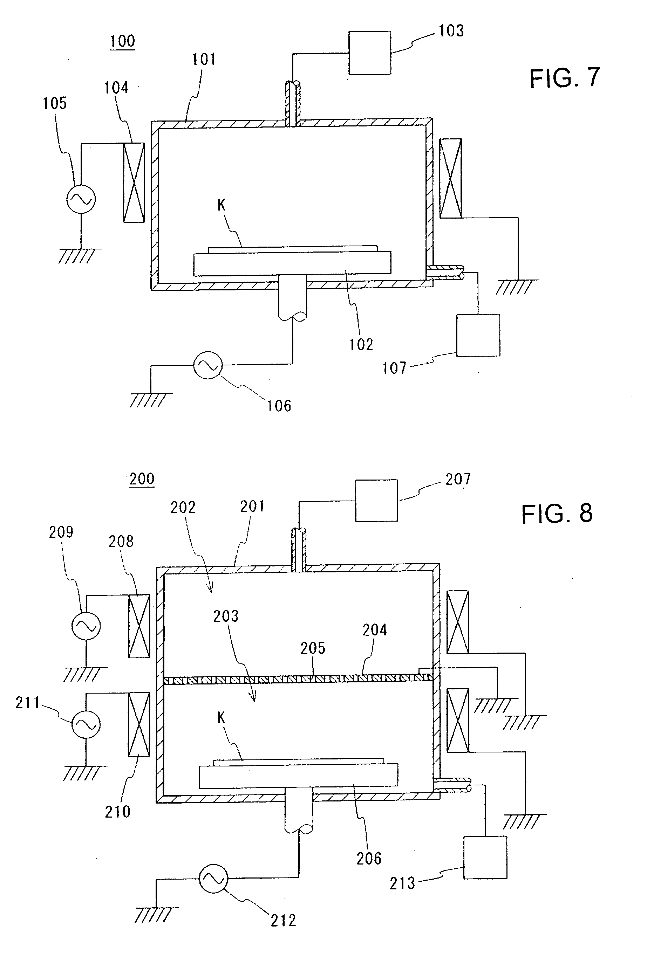

A plasma etching apparatus 100 shown in Fig. 7 has a processing chamber 101, a platen 102 which is disposed in the lower part in the processing chamber 101 and on which a substrate K is placed, a gas supply device 103 for supplying an etching gas into the processing chamber 101, a coil 104 arranged on the outer periphery of the processing chamber 101, an RF power supply unit 105 for supplying RF power to the coil 104, an RF power supply unit 106 for supplying RF power to the platen 102 and an exhaust device 107 for exhausting the gas within the processing chamber 101.

In the plasma etching apparatus 100, an etching gas supplied into the processing chamber 101 is excited into a plasma by supplying RF power to the coil 104, and the substrate K on the platen 102 is etched by radicals in the plasma and by ions in the plasma which are incident on the substrate K due to a bias potential generated by supplying RF power to the platen 102.

On the other hand, a plasma etching apparatus 200 shown in Fig. 8 has a processing chamber 201 having an inner space in which two plasma generating regions 202, 203 are vertically arranged, a grounded plate-shaped member 204 which divides the processing chamber 201 so that spaces of approximately the same size are formed to be vertically arranged and the plasma generating region 202 and the plasma generating region 203 are provided on the upper side and on the lower side, respectively, and which has a plurality of through holes 205 penetrating from the top surface to the bottom surface thereof, a platen 206 which is disposed in the lower part in the processing chamber 201 and on which a substrate K is placed, a gas supply device 207 for supplying an etching gas into the processing chamber 201 from the upper side thereof, a coil 208 arranged on the outer periphery of the processing chamber 201 in such a manner that it corresponds to the plasma generating region 202, an RF power supply unit 209 for supplying RF power to the coil 208, a coil 210 arranged on the outer periphery of the processing chamber 201 in such a manner that it corresponds to the plasma generating region 203, an RF power supply unit 211 for supplying RF power to the coil 210, an RF power supply unit 212 for supplying RF power to the platen 206 and an exhaust device 213 for exhausting the gas within the processing chamber 201 from the lower side thereof.

In the plasma etching apparatus 200, an etching gas supplied into the processing chamber 201 flows from the plasma generating region 202 into the plasma generating region 203 through the through holes 205 of the plate-shaped member 204 and RF power is supplied to the coil 208 and to the coil 210. Thereby, the etching gases in the plasma generating regions 202, 203 are each excited into a plasma and the substrate K on the platen 206 is etched by radicals in the plasma within the plasma generating region 203 and by ions in the plasma within the plasma generating region 203 which are incident on the substrate K due to a bias potential generated by supplying RF power to the platen 206.

Further, when the etching gas passes through the plate-shaped member 204, ions in the etching gas (in the plasma) are brought into contact with the plate-shaped member 204 and thereby disappear and only radicals pass through the plate-shaped member 204. Therefore, the radical density in the plasma generating region 203 is high and the substrate K is etched by the radicals and the ions.

### Citation List

Patent Literature
*Patent document 1:* Japanese Unexamined Patent Application Publication No. 2006-54305
*Patent document 2:* Japanese Unexamined Patent Application Publication (Translation of PCT Application) No. 2003-533878

### Summary of Invention

### Technical Problem

By the way, the substrate K to be etched includes substrates which are etched mainly by ions incident thereon, such as, for example, silicon dioxide (SiO₂) substrates, and substrates which are etched mainly by chemical reaction with radicals, such as, for example, silicon (Si) substrates. Depending on the substrate K, the progress of etching is different, the substrate K is etched mainly by incidence of ions or is etched mainly by chemical reaction with radicals.

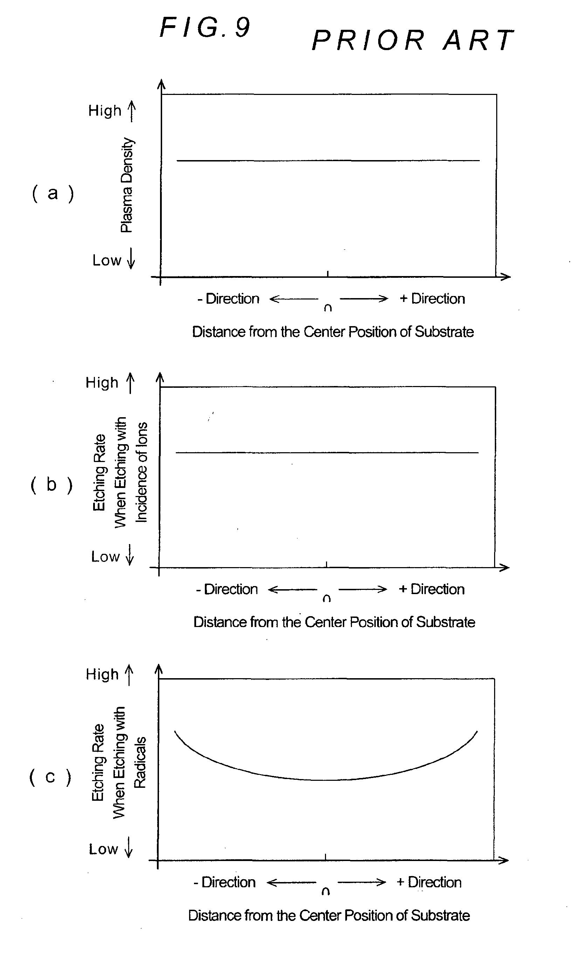

In the plasma etching apparatus 100 shown in Fig. 7, in a case where the substrate K is etched mainly by incidence of ions, when the plasma density (ion density) of the generated plasma is made uniform as shown in Fig. 9 (a), the entire surface of the substrate K can be etched uniformly at a uniform etching rate (refer to Fig. 9(b)). However, in a case where the substrate K is etched mainly by chemical reaction with radicals, since the radical density is also uniform when the plasma density is uniform, there occurs a disadvantage that the etching rate at the peripheral portion of the substrate K is high due to the loading effect and therefore the entire surface of the substrate K cannot be etched uniformly (refer to Fig. 9(c)).

It is noted that the loading effect is caused by the fact that more number of radicals contribute to etching at the peripheral portion of the substrate K than at the central portion of the substrate K because a large volume of plasma is generated outside the peripheral portion of the substrate K.

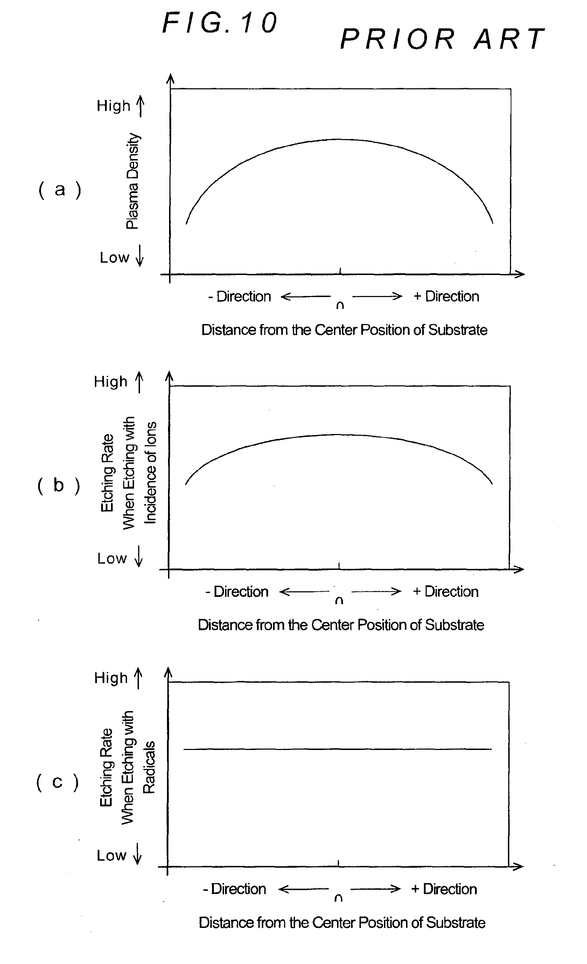

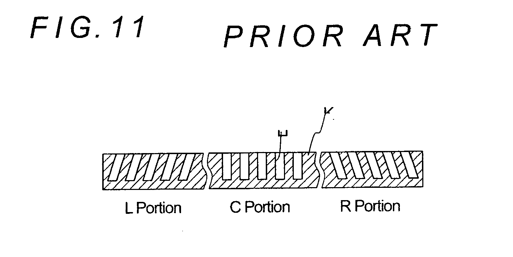

On the other hand, when the plasma density is made high at the central portion of the substrate K and low at the peripheral portion thereof as shown in Fig. 10(a), the radical density distribution becomes similar to the plasma density distribution. Therefore, in a case where the substrate K is etched mainly by chemical reaction with radicals, the etching rate at the central portion of the substrate K where the radical density is high is increased to the same degree as the etching rate at the peripheral portion of the substrate K, and thereby it is made possible to uniformly etch the entire surface of the substrate K (refer to Fig. 10(c)). However, in a case where the substrate K is etched mainly by incidence of ions, there occurs a disadvantage that the etching rate at the central portion of the substrate K is increased and therefore the entire surface of the substrate K cannot be etched uniformly (refer to Fig. 10(b)), and a disadvantage that, as shown in Fig. 11, the peripheral portion of the substrate K cannot be etched accurately due to ions obliquely incident thereon. That is, as shown in Fig. 11, although a groove H or a hole H is formed perpendicular to the surface at the central portion (C portion) of the substrate K, an groove H or a hole H is formed oblique to the surface at the peripheral portion (L portion, R portion) of the substrate K.

Therefore, in the plasma etching apparatus 100 shown in Fig. 7, only either one of substrates K which are etched mainly by ions incident thereon and substrates K which are etched mainly by chemical reaction with radicals can be etched uniformly and it is not possible to uniformly etch both of them.

On the other hand, in the plasma etching apparatus 200 shown in Fig. 8, although the radical density in the plasma generating region 203 can be increased by means of the plate-shaped member 204, a problem similar to the above one occurs also in the plasma etching apparatus 200 because the radical density is increased not partially but as a whole.

The present invention has been achieved in view of the above-described circumstances, and an object thereof is to provide a plasma etching method capable of uniformly etching the entire surface of a substrate regardless of the kind of the substrate, that is, both when the substrate is etched mainly by chemical reaction with radicals and when the substrate is etched mainly by incidence of ions.

### Solution to Problem

The present invention, for achieving the above-described object, relates to a plasma etching method as described in independent patent claim 1.

According to the invention, the pressure within the processing chamber is reduced by the exhaust means and a processing gas including an etching gas is supplied into the upper chamber by the gas supply means, and the supplied processing gas flows from the upper chamber toward the lower chamber and is excited into a plasma by the first plasma generating means and by the second plasma generating means. Further, RF power is supplied to the platen by the power supply means and thereby a potential difference (bias potential) is generated between the platen and the plasma generated from the processing gas in the lower chamber. A substrate on the platen is etched by radicals in the plasma in the lower chamber and by ions which are incident on the substrate due to the bias potential.

Although ions in the processing gas which has been excited into a plasma by the first plasma generating means and which flows from the upper chamber into the lower chamber (ions in the plasma) are removed by the ion removing means, radicals in the processing gas move into the lower chamber without being removed. Further, the upper chamber has an outer diameter smaller than the outer diameter of the lower chamber and is provided at the central portion of the top surface of the lower chamber. Thereby, the radical density at the central portion of the substrate in the lower chamber can be increased without changing the plasma density (ion density).

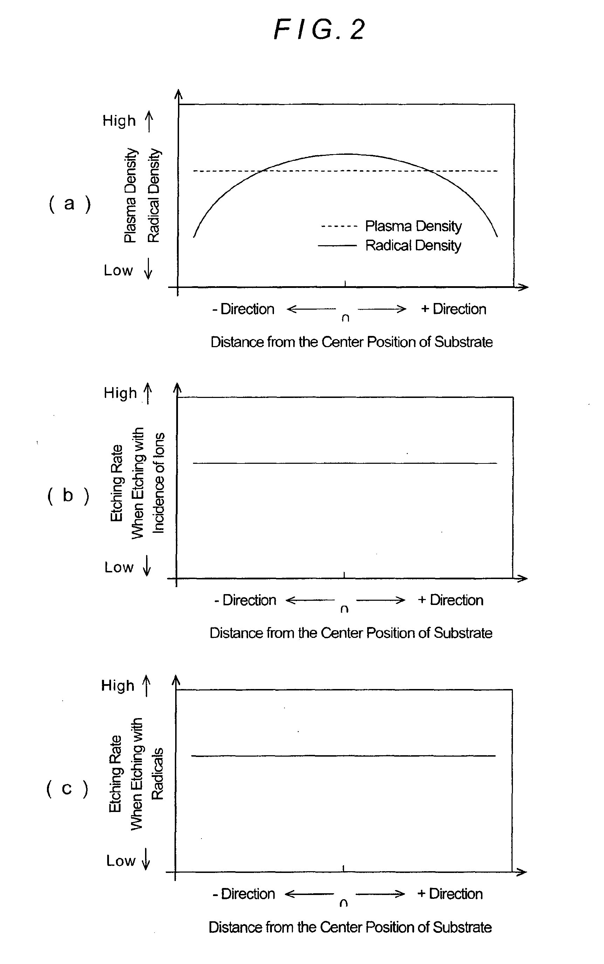

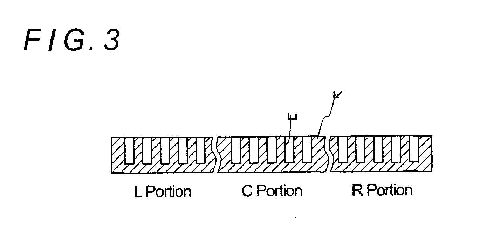

Therefore, for example, when the plasma density and the radical density of the plasma which is generated in the lower chamber by the second plasma generating means are each uniform, the radical density at the central portion of the substrate can be increased by the quantity of radicals which moved from the upper chamber into the lower chamber as compared to that at the peripheral portion of the substrate while the plasma density is held constant (refer to Fig. 2(a)). Therefore, in a case where a substrate to be etched is etched mainly by chemical reaction with radicals, the etching rate at the central portion of the substrate can be increased to the same degree as the etching rate at the peripheral portion of the substrate affected by the loading effect (refer to Fig. 2(c)), and as a result, it is possible to uniformly etch the entire surface of the substrate. On the other hand, in a case where a substrate to be etched is etched mainly by incidence of ions, it is possible to uniformly etch the entire surface of the substrate at a uniform etching rate with ions distributed uniformly (refer to Fig. 2(b)). Further, as shown in Fig. 3, a groove H or a hole H can be formed perpendicular to the surface of the substrate both at the central portion (C portion) of the substrate K and at the peripheral portion (L portion, R portion) of the substrate K.

Thus, according to the plasma etching method of the present invention, the entire surface of a substrate can be etched uniformly both when the substrate is etched mainly by chemical reaction with radicals and when the substrate is etched mainly by incidence of ions because it is possible to make the radical density at the central portion of the substrate higher than that at the peripheral portion of the substrate without changing the plasma density.

It is noted that the ion removing means may be configured by a grounded plate-shaped member having a plurality of through holes penetrating from the top surface to the bottom surface thereof, the plate-shaped member being disposed in the lower part in the upper chamber or in the upper part in the lower chamber in such a manner that it divides the inner space of the processing chamber. In this case, the processing gas flowing from the upper chamber into the lower chamber passes through the plate-shaped member on the way to the lower chamber, and at this time, ions in the processing gas (in the plasma) are brought into contact with the plate-shaped member and thereby disappear and radicals move into the lower chamber without disappearing.

Further, a configuration is possible in which: at least either the lower part of the upper chamber or the upper part of the lower chamber has a grounded portion formed thereon; the ion removing means has a coil which is disposed on the outer periphery of the upper chamber in such a manner that it winds around the upper chamber and a DC power supply unit for passing a direct current through the coil; and ions in the processing gas excited into a plasma by the first plasma generating means are moved toward the inner surface of the grounded portion of the processing chamber due to a magnetic field generated by the coil through which a direct current is being passed and are bought into contact with the inner surface. In this case, ions in the processing gas (plasma) flowing from the upper chamber into the lower chamber are moved toward the inner surface of the grounded portion of the processing chamber due to a magnetic field generated by the coil through which a direct current is being passed and are brought into contact with the inner surface and thereby disappear and radicals in the processing gas are moved into the lower chamber without disappearing.

Furthermore, the ion removing means may be configured by the upper chamber which has a plasma generating region defined in the upper part of the inner space thereof and is grounded at a portion below the plasma generating region thereof or by the upper chamber which has a plasma generating region defined in the upper part of the inner space thereof and the lower chamber which has a grounded annular plate as a top plate, the plasma generating region being defined at an upper position apart from the lower end of the upper chamber so that ions in the processing gas excited into a plasma by the first plasma generating means in the plasma generating region can be brought into contact with the inner surface of the grounded component. In this case, the processing gas supplied into the upper chamber is excited into a plasma in the plasma generating region and flows into the lower chamber after passing through the grounded portion of the upper chamber or on the inner peripheral surface of the annular plate, and when passing through the grounded portion or on the inner peripheral surface of the annular plate, ions in the processing gas (in the plasma) are brought into contact with the inner surface of the grounded portion or the inner peripheral surface of the annular plate and thereby disappear and radicals in the processing gas move into the lower chamber after passing through the grounded portion or on the inner peripheral surface of the annular plate without disappearing. Therefore, also when thus configured, although not in a positive manner, it is possible to remove ions. It is noted that the height of the upper chamber, the height position of the plasma generating region and the thickness of the annular plate preferable for bringing ions in the processing gas excited into a plasma in the plasma generating region into contact with the inner surface of the grounded portion of the upper chamber or the inner peripheral surface of the annular plate to remove them are obtained experimentally, for example.

### Advantageous Effects of Invention

As described above, according to the plasma etching apparatus of the present invention, it is possible to make the etching rate of substrate uniform as shown in Fig. 2 and thereby uniformly etch the entire surface of a substrate to be etched with radicals and incidence of ions, regardless of the type of the substrate. Brief Description of Drawings
Fig. 1 is a sectional view showing a schematic configuration of a plasma etching apparatus used in one embodiment of the present invention;
Fig. 2 shows a graph showing a plasma density distribution and a radical
   density distribution in a lower chamber in the embodiment in (a), and graphs showing etching rates for etching a substrate using the plasma etching method according to the embodiment in (b) and (c);
Fig. 3 is a sectional view showing etching shapes obtained when a substrate is etched using the plasma etching method according to the embodiment;
Fig. 4 is a sectional view showing a schematic configuration of the plasma etching apparatus used in another embodiment of the present invention;
Fig. 5 is a sectional view showing a schematic configuration of the plasma etching apparatus used in another embodiment of the present invention;
Fig. 6 is a sectional view showing a schematic configuration of the plasma etching apparatus used in another embodiment of the present invention;
Fig. 7 is a sectional view showing a schematic configuration of a plasma etching apparatus according to a prior-art example;
Fig. 8 is a sectional view showing a schematic configuration of a plasma etching apparatus according to a prior-art example;
Fig. 9 shows graphs relating to a plasma density distribution and etching rates, which are used for explaining a conventional problem;
Fig. 10 shows graphs relating to a plasma density distribution and etching rates, which are used for explaining a conventional problem; and
Fig. 11 is a sectional view showing etching shapes, which is used for explaining a conventional problem.

### Description of Embodiments

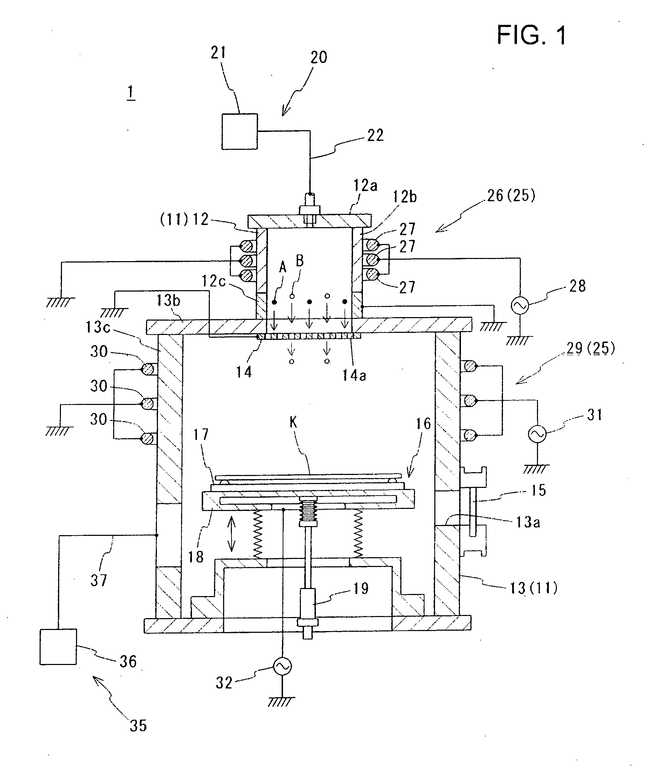

Hereinafter, a specific embodiment of the present invention will be described on the basis of the accompanying drawings. Fig. 1 is a sectional view showing a schematic configuration of a plasma etching apparatus used in the method of one embodiment of the present invention.

As shown in Fig. 1, a plasma etching apparatus 1 of the embodiment has a processing chamber 11 having a closed space, a platen 16 which is disposed in the processing chamber 11 and on which a substrate K to be etched is placed, a gas supply device 20 for supplying an etching gas (processing gas) into the processing chamber 11, a plasma generating device 25 for exciting into a plasma an etching gas supplied into the processing chamber 11, an RF power supply unit 32 for supplying RF power to the platen 16 and an exhaust device 35 for reducing the pressure within the processing chamber 11.

The processing chamber 11 is formed in a vertically two-divided configuration comprising an upper chamber 12 and a lower chamber 13, and each of the upper chamber 12 and the lower chamber 13 is configured by a cylindrical-container shaped member. Further, the upper chamber 12 has an opening in the bottom thereof and the lower chamber 13 has an opening at the top thereof, and inner spaces of the upper chamber 12 and the lower chamber 13 communicate with each other.

The upper chamber 12 is formed to have an outer diameter smaller than the outer diameter of the lower chamber 13 and is disposed at the central portion of the top surface of the lower chamber 13. On the ceiling of the lower chamber 13, a grounded plate-shaped member (ion removing member) 14 is provided which divides the inner space of the processing chamber 11 into a space on the upper chamber 12 side and a space on the lower chamber 13 side. The plate-shaped member 14 has a plurality of through holes 14a penetrating from the top surface to the bottom surface thereof and is made of metal such as, for example, aluminum. Further, the lower chamber 13 has an opening 13a provided in the peripheral surface thereof for loading and unloading the substrate K and the opening 13a is opened and closed by a shutter 15.

It is noted that a top plate 12a and a lower side wall 12c of the upper chamber 12 and a top pate (annular plate) 13b of the lower chamber 13 are made of metal such as, for example, aluminum, and an upper side wall 12b of the upper chamber 12 and a side wall 13c of the lower chamber 13 are made of, for example, ceramics, and, for example, the lower side wall 12c of the upper chamber 12 and the top plate 13b of the lower chamber 13 are grounded.

The platen 16 comprising an upper member 17 and a lower member 18 and is disposed in the lower chamber 13. The substrate K is placed on the upper member 17 and a lifting cylinder 19 for lifting the platen 16 is connected to the lower member 18.

The gas supply device 20 comprises a supply section 21 for supplying an etching gas (for example, SF₆ gas) and a supply pipe 22 connected to the supply section 21 at one end thereof and to the upper part of the upper chamber 12 at the other end thereof, and an etching gas is supplied into the upper chamber 12 from the supply section 21 through the supply pipe 22.

The plasma generating device 25 comprises a first plasma generating section 26 having a plurality of annular coils 27 which are vertically aligned on the outer periphery of the upper chamber 12 and an RF power supply unit 28 for supplying RF power to the coils 27, and a second plasma generating section 29 having a plurality of annular coils 30 which are vertically aligned on the outer periphery of the lower chamber 13 and an RF power supply unit 31 for supplying RF power to the coils 30. It is noted that the coils 30 are provided on a portion higher than the platen 16 of the upper part of the lower chamber 13.

When, in the plasma generating sections 26, 29, RF power is supplied to the coils 27, 30 by the RF power supply units 28, 31, respectively, in each of the chambers 12, 13, a magnetic field is generated and an etching gas therein is excited into a plasma due to an electric field caused by the magnetic field, and radicals, ions, electrons and the like are generated.

Further, when RF power is supplied to the platen 16 by the RF power supply unit 32, a potential difference (bias potential) is generated between the platen 16 and the plasma generated in the lower chamber 13.

The exhaust device 35 comprises an exhaust pump 36 and an exhaust pipe 37 connecting the exhaust pump 36 to the lower chamber 13, and exhausts the gas within the lower chamber 13 through the exhaust pipe 37 by means of the exhaust pump 36 and thereby reduces the pressure within the processing chamber 11 to a predetermined pressure.

According to the plasma etching apparatus 1 of the embodiment thus configured, after a substrate K is placed on the platen 16 in the lower chamber 13, RF power is supplied to the coils 27, the coils 30 and the platen 16 by the RF power supply units 28, 31, 32, respectively, the pressure within the processing chamber 11 is reduced by the exhaust device 35, and an etching gas is supplied into the processing chamber 11 by the gas supply device 20.

A part of the supplied etching gas is excited into a plasma and flows from the upper chamber 12 toward the lower chamber 13, and, after passing through the through holes 14a of the plate-shaped member 14, flows into the lower chamber 13 and is diffused. At this time, ions A in the etching gas (in the plasma) are brought into contact with the plate-shaped member 14 and thereby disappear, and the etching gas which is not excited into a plasma and radicals B in the plasma flow into the lower chamber 13 (refer to Fig. 1). In the lower chamber 13, similarly to the upper chamber 12, a part of the etching gas which flowed thereinto is excited into a plasma.

On the other hand, the substrate K placed on the platen 16 in the lower chamber 13 is etched by chemical reaction with radicals in the plasma within the lower chamber 13 or etched by ions in the plasma which are incident on the substrate K due to the bias potential.

By the way, as described above, when the etching gas excited into a plasma passes through the plate-shaped member 14, ions in the etching gas (in the plasma) are brought into contact with the plate-shaped member 14 and thereby disappear, and on the other hand, radicals flow into the lower chamber 13 without disappearing. Further, the upper chamber 12 has an outer diameter smaller than the outer diameter of the lower chamber 13 and is disposed at the central portion of the top surface of the lower chamber 13.

For this reason, in the lower chamber 13, the radical density at the central portion of the substrate K is increased by the radicals which flowed thereinto from the upper chamber 12, and the plasma density (ion density) in the lower chamber 13 is not changed by the etching gas flowing thereinto from the upper chamber 12.

Therefore, for example, if the plasma density and the radical density of the plasma generated in the lower chamber 13 are each uniform, as shown in Fig. 2(a), the radical density at the central portion of the substrate K can be increased by the quantity of radicals which move from the upper chamber 12 to the lower chamber 13 as compared with the radical density at the peripheral portion of the substrate K while the plasma density is held constant.

Thereby, in a case where the substrate K to be etched is etched mainly by chemical reaction with radicals, as shown in Fig. 2(c), the etching rate at the central portion of the substrate K can be increased to the same degree as the etching rate at the peripheral portion of the substrate K affected by the loading effect, and as a result, it is possible to uniformly etch the entire surface of the substrate K. On the other hand, in a case where the substrate K to be etched is etched mainly by incidence of ions, as shown in Fig. 2(b), it is possible to uniformly etch the entire surface of the substrate K at a uniform etching rate with ions distributed uniformly. Further, as shown in Fig. 3, both at the central portion (C portion) of the substrate K and at the peripheral portion (L portion, R portion) of the substrate K, a groove H or a hole H can be formed perpendicular to the surface.

Thus, according to the plasma etching apparatus 1 of the embodiment, it is possible to make the radical density at the central portion of the substrate K higher than the radical density at the peripheral portion of the substrate K without changing the plasma density. Therefore, both when the substrate K is etched mainly by chemical reaction with radicals and when the substrate K is etched mainly by incidence of ions, it is possible to make the etching rate of the substrate K uniform as shown in Fig. 2 and thereby uniformly etch the entire surface of the substrate K.

Thus, one embodiment of the present invention has been described. However, a specific embodiment in which the present invention can be implemented is not limited thereto.

In the embodiment, the plate-shaped member 14 with which the ions generated by exciting the etching gas into a plasma in the upper chamber 12 are brought into contact so as to be removed is provided on the ceiling of the lower chamber 13. However, there is no limitation to the mode of disposing the plate-shaped member 14, and the plate-shaped member 14 may be provided on the inner peripheral surface of a lower portion of the upper chamber 12 to bring the ions in the etching gas into contact therewith to remove them before the etching gas in actual flows into the lower chamber 13. Alternatively, the plate-shaped member 14 may be provided on the inner peripheral surface of an upper portion of the lower chamber 13 to bring the ions in the etching gas into contact therewith to remove them immediately after the etching gas flows into the lower chamber 13.

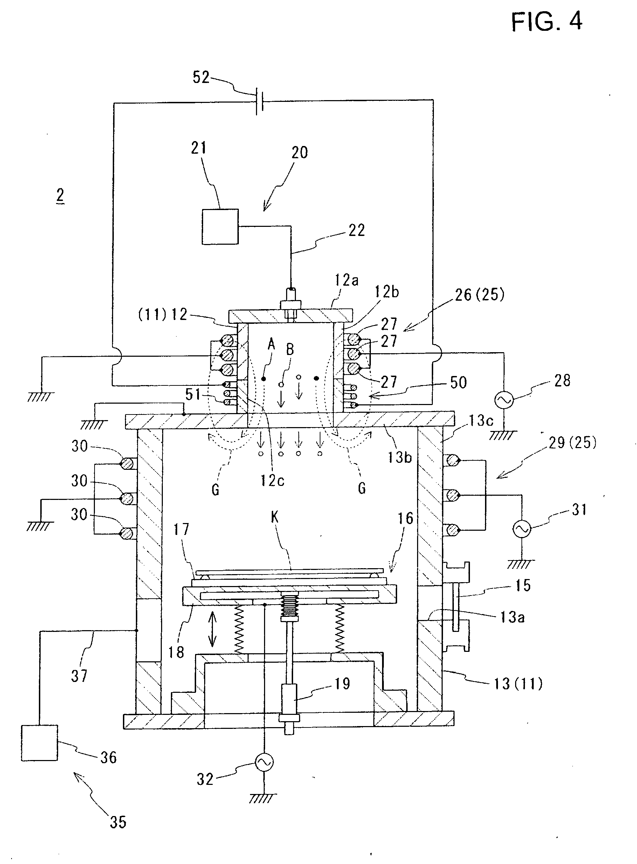

Further, it is possible to remove the ions in the etching gas by means of the generation of a magnetic field instead of the contact with the plate-shaped member 14. In this case, a plasma etching apparatus 2 has, as shown in Fig. 4, instead of the plate-shaped member 14, a removing device 50 comprising a coil 51 disposed on a lower portion of the outer periphery of the upper chamber 12 in such a manner that it winds around the upper chamber 12 and a DC power supply unit 52 for passing a direct current through the coil 51. It is noted that the plasma etching apparatus 2 has the same configuration as that of the plasma etching apparatus 1, except for the removing device 50.

The DC power supply unit 52 passes a direct current through the coil 51 so that a magnetic field with magnetic lines of force G in the direction as shown in Fig. 4 is generated when the direct current is passed through the coil 51. That is, a direct current is passed through the coil 51 so that a magnetic field in which the magnetic lines of force G are directed downward inside the coil 51 and directed upward outside the coil 51 is generated by the coil 51.

According to the removing device 50 thus configured, ions A which are generated by exciting an etching gas into a plasma in the upper chamber 12 move, due to a magnetic field generated by the coil 51, along the direction of the magnetic lines of force G and are brought into contact with the inner surface of the processing chamber 11 (mainly, with the ceiling of the lower chamber 13 (the annular plate 13b)) and thereby disappear. Therefore, the ions A in the etching gas which flowed from the upper chamber 12 into the lower chamber 13 disappear immediately and radicals B in the etching gas move downward without disappearing. Therefore, also in the plasma etching apparatus 2, a similar effect to that of the plasma etching apparatus 1 can be obtained.

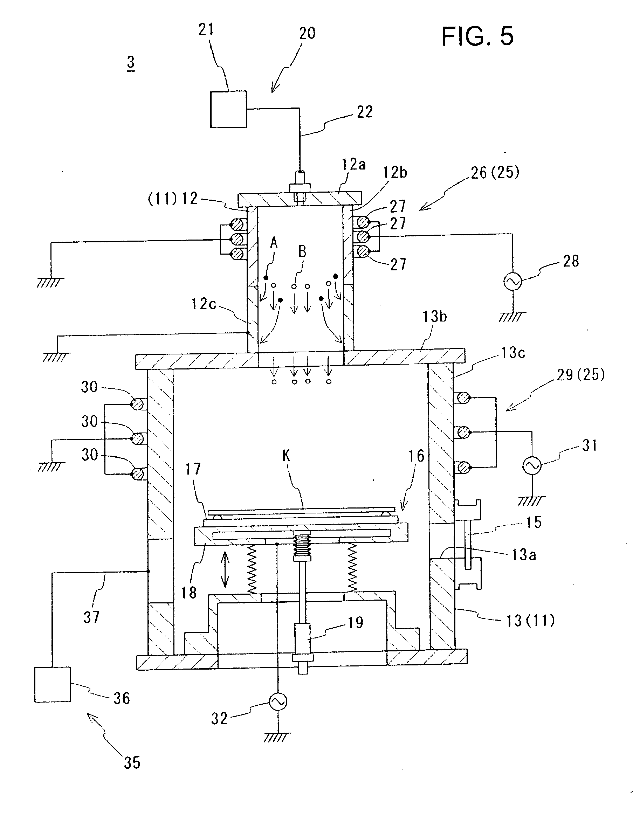

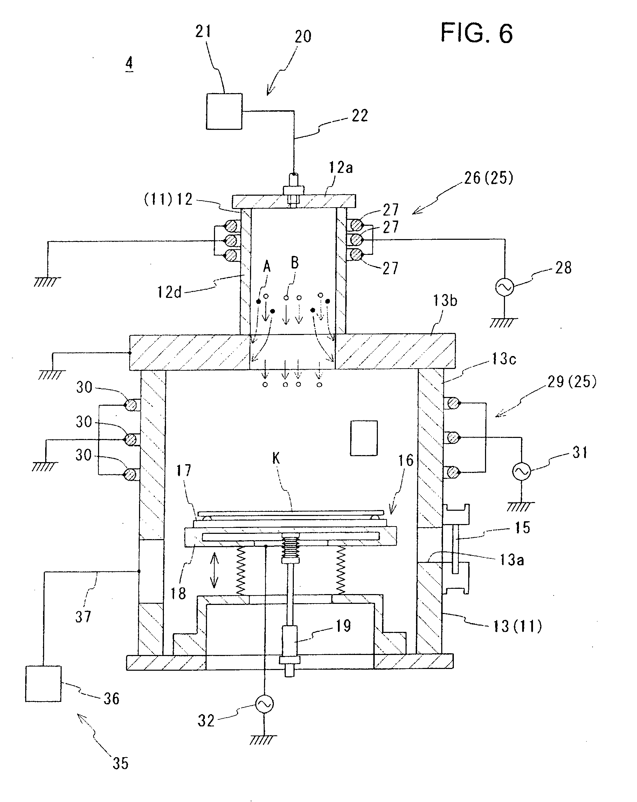

Further, for removing ions in the etching gas, plasma etching apparatuses 3, 4 may be configured as shown in Figs. 5 and 6, respectively. The plasma etching apparatus 3 shown in Fig. 5 is configured in such a manner that: the upper chamber 12 itself has a removing function, and is formed in a vertically long shape and has a plasma generating region defined in the upper part of the inner space thereof; and a portion below the plasma generating region corresponds to the lower side wall 12c. It is noted that the plasma etching apparatus 3 has the same configuration as that of the plasma etching apparatus 1, except for the length of the upper chamber 12 and the plate-shaped member 14. Further, the lower side wall 12c functions as a portion with which ions in a processing gas excited into a plasma in the plasma generating region are brought into contact so as to be removed, and the height of the upper chamber 12 and the height position of the plasma generating region for causing the lower side wall 12c to function as described above can be obtained experimentally, for example.

On the other hand, the plasma etching apparatus 4 shown in Fig. 6 is configured in such a manner that: the structures of the upper chamber 12 and the lower chamber 13 achieve a removing function; the upper chamber 12 is formed in a vertically long shape and has a plasma generating region defined in the upper part of the inner space thereof; and the top plate (annular plate) 13b of the lower chamber 13 is formed thick. Further, for a side wall 12d of the upper chamber 12, the member forming the upper part thereof and the member forming the lower part thereof are not different from each other, and the side wall 12d is made of, for example, ceramics. It is noted that the plasma etching apparatus 4 has the same configuration as that of the plasma etching apparatus 1, except for the upper chamber 12, the thickness of the annular plate 13b of the lower chamber 13 and the plate-shaped member 14. Further, the annular plate 13b functions as a portion with which ions in a processing gas excited into a plasma in the plasma generating region are brought into contact so as to be removed, and the height of the upper chamber 12, the height position of the plasma generating region and the thickness of the annular plate 13b for causing the annular plate 13b to function as described above can be obtained experimentally, for example.

According to the plasma etching apparatuses 3, 4 thus configured, an etching gas supplied into the upper chamber 12 is excited into a plasma in the plasma generating region and flows into the lower chamber 12 after passing through the lower side wall 12c and on the inner peripheral surface of the annular plate 13b. In the plasma etching apparatus 3 of Fig. 5, when the etching gas passes through the lower side wall 12c, ions A in the etching gas are brought into contact with the inner surface of the lower side wall 12c and thereby disappear, and in the plasma etching apparatus 4 of Fig. 6, when the etching gas passes on the inner peripheral surface of the annular plate 13b, ions A in the etching gas are brought into contact with the inner peripheral surface of the annular plate 13b and thereby disappear, and on the other hand, radicals B move downward though the lower side wall 12c and on the inner peripheral surface of the annular plate 13b without disappearing. Therefore, also when, as the plasma etching apparatuses 3, 4, the apparatus is configured in such a manner that the upper chamber 12 is formed in a vertically long shape and a plasma generating region is defined in the upper part of the inner space thereof and thereby the plasma generating region is separated from the lower end of the upper chamber 12, a similar effect to that of the plasma etching apparatus 1 can be obtained.

Further, the mode of removing ions in an etching gas excited into a plasma is not limited to the above-described modes, and it is possible to bring the ions into contact with a grounded member (including a part of a member) to remove them by means of another mode.

Furthermore, although, in the embodiments, an etching gas is supplied directly only into the upper chamber 12, the mode of supply of etching gas is not limited thereto, and an etching gas may be supplied into each of the upper chamber 12 and the lower chamber 13 by the gas supply device 20.

### Reference Signs List

- 1: Plasma etching apparatus
- 11: Processing chamber
- 12: Upper chamber
- 13: Lower chamber
- 14: Plate-shaped member
- 16: Platen
- 20: Gas supply device
- 25: Plasma generating device
- 26: First plasma generating section
- 27: Coil
- 28: RF power supply unit
- 29: Second plasma generating section
- 30: Coil
- 31: RF power supply unit
- 35: Exhaust device
- K: Substrate

## Claims

1. A plasma etching method of plasma etching a substrate (K) using a plasma etching
apparatus (1; 2; 3; 4), the plasma etching apparatus (1; 2; 3; 4) comprising:
a processing chamber (11) including an upper chamber (12) which is configured by a cylindrical-container shaped member having an opening in the bottom thereof and a lower chamber (13) which is configured by a cylindrical-container shaped member having an opening in the top thereof, the upper and lower chambers (12, 13) being disposed to be vertically aligned and having respective inner spaces communicating with each other, the upper chamber (12) being formed to have an outer diameter smaller than the outer diameter of the lower chamber (13) and being provided at a central portion of the top surface of the lower chamber (13);
a platen (16) which is disposed in the lower chamber (13) and on which the substrate (K) is placed;
gas supply means (20) for supplying a processing gas including an etching gas at least into the upper chamber (12);
first plasma generating means (26) including a coil (27) which is provided on the outer periphery of the upper chamber (12) and to which RF power is supplied, and exciting the processing gas supplied into the upper chamber (12) into a plasma;
second plasma generating means (29) including a coil (30) which is provided on the outer periphery of the lower chamber (13) and to which RF power is supplied, and exciting the processing gas flowing from the upper chamber (12) into the lower chamber (13) into a plasma;
exhaust means (35) for exhausting the gas within the processing chamber (11) to reduce the pressure within the processing chamber (11);
power supply means (32) for supplying RF power to the platen (16); and
ion removing means (14; 50; 12c; 13b) for removing ions (A) from the processing gas excited into the plasma by the first plasma generating means (26) and flowing from the upper chamber (12) into the lower chamber (13),
wherein in the plasma etching method,
the processing gas supplied into the upper chamber (12) is excited into a plasma by the first plasma generating means (26),
the processing gas excited into the plasma is caused to flow from the upper chamber (12) into the lower chamber (13) and ions (A) in the processing gas are removed by the ion removing means (14; 50; 12c; 13b) while the processing gas flows from the upper chamber (12) into the lower chamber (13), and
the plasma etching method is **characterized in that**:
the part of the processing gas, which has not been excited into a plasma and flows from the upper chamber (12) into the lower chamber (13), is excited into a plasma by the second plasma generating means (29) in the lower chamber (13) so that radical (B) density and ion (A) density of the plasma are each uniform over the entire top surface of the substrate (K),
the plasma in the lower chamber (13) is adjusted by the processing gas flowing from the upper chamber (12) into the lower chamber (13) and by the excitation into plasma by the second plasma generating means (29) so that the ion (A) density of the plasma is uniform over the entire top surface of the substrate (K) and the radical (B) density of the plasma at a central portion of the substrate (K) becomes higher than that at a peripheral portion of the substrate (K), and
the substrate (K) is etched by the adjusted plasma.

2. The plasma etching method according to claim 1, **characterized in that**
the ion removing means (14) is configured by a grounded plate-shaped member (14) having a plurality of through holes (14a) penetrating from the top surface to the bottom surface thereof,
the plate-shaped member (14) is disposed in a lower part of the upper chamber (12) or in an upper part of the lower chamber (13) in such a manner that it divides the inner space of the processing chamber (11), and
ions (A) in the processing gas flowing from the upper chamber (12) into the lower chamber (13) are removed by the ion removing means (14).

3. The plasma etching method according to claim 1, **characterized in that**
at least either a lower part of the upper chamber (12) or an upper part of the lower chamber (13) has a grounded portion formed thereon, and
the ion removing means (50) has a coil (51) which is disposed on the outer periphery of the upper chamber (12) in such a manner that it winds around the upper chamber (12) and a DC power supply unit (52) for passing a direct current through the coil (51), and is configured to move ions (A) in the processing gas excited into the plasma by the first plasma generating means (26) toward the inner surface of the grounded portion of the processing chamber (11) by means of a magnetic field generated by the coil (51) through which a direct current is being passed and bring them into contact with the inner surface of the grounded portion of the processing chamber (11) to thereby remove the ions (A) from the processing gas.

4. The plasma etching method according to claim 1, **characterized in that**
a lower portion of the upper chamber (12) corresponding to a region below a plasma generating region in which the processing gas is excited into the plasma by the first plasma generating means (26) in the inner space of the upper chamber (12) our an annular top plate of the lower chamber (13) to which the upper chamber (12) is connected is made of a grounded metal and the lower portion of the upper chamber (12) or top plate of the lower chamber (13) made of the grounded metal is provided to be exposed in the inner space of the processing chamber (11), and
the ion (A) removing means include the grounded lower portion of the upper chamber (12) or the grounded top plate of the lower chamber (13), and is configured to remove the ions in the processing gas by bringing the ions into contact with the grounded lower portion of the upper chamber (12) or the grounded top plate of the lower chamber (13).

## Patentansprüche

1. Plasmaätzverfahren zum Plasmaätzen eines Substrats (K) unter Verwendung einer Plasmaätzvorrichtung (1; 2; 3; 4), wobei die Plasmaätzvorrichtung (1; 2; 3; 4) Folgendes umfasst:
- eine Verarbeitungskammer (11), die eine obere Kammer (12) umfasst, die durch ein Element in Form eines zylindrischen Behälters ausgebildet ist, das eine Öffnung in seinem Boden aufweist, und eine untere Kammer (13) umfasst, die durch ein Element in Form eines zylindrischen Behälters ausgebildet ist, das eine Öffnung in seiner Oberseite aufweist, wobei die obere und die untere Kammer (12, 13) so angeordnet sind, dass sie vertikal aufeinander ausgerichtet sind, und jeweilige Innenräume aufweisen, die miteinander in Strömungsverbindung stehen, wobei die obere Kammer (12) so gebildet ist, dass ihr Außendurchmesser kleiner ist als der Außendurchmesser der unteren Kammer (13), und dass sie an einem mittigen Abschnitt der Oberseite der unteren Kammer (13) angeordnet ist;
- eine Platte (16), die in der unteren Kammer (13) angeordnet ist und auf der das Substrat (K) angeordnet wird;
- ein Gaszufuhrmittel (20) zum Zuführen eines Prozessgases, das ein Ätzgas enthält, mindestens in die obere Kammer (12);
- ein erstes Plasmaerzeugungsmittel (26), das eine Spule (27) umfasst, die am Außenumfangsrand der oberen Kammer (12) angeordnet ist und die mit einer Hochfrequenzleistung beaufschlagt wird, und die das in die obere Kammer (12) eingeleitete Prozessgas zu einem Plasma erregt;
- ein zweites Plasmaerzeugungsmittel (29), das eine Spule (30) umfasst, die am Außenumfangsrand der unteren Kammer (13) angeordnet ist und die mit einer Hochfrequenzleistung beaufschlagt wird, und die das Prozessgas, das aus der oberen Kammer (12) in die untere Kammer (13) strömt, zu einem Plasma erregt;
- ein Abzugsmittel (35) zum Abziehen des Gases innerhalb der Verarbeitungskammer (11), um den Druck innerhalb der Verarbeitungskammer (11) zu reduzieren;
- ein Stromversorgungsmittel (32) zum Zuführen von Hochfrequenzleistung zu der Platte (16); und
- ein Ionenabzugsmittel (14; 50; 12c; 13b) zum Abziehen von Ionen (A) aus dem Prozessgas, das durch das erste Plasmaerzeugungsmittel (26) zu einem Plasma erregt wurde und aus der oberen Kammer (12) in die untere Kammer (13) strömt,
wobei in dem Plasmaätzverfahren
das in die obere Kammer (12) eingeleitete Prozessgas durch das erste Plasmaerzeugungsmittel (26) zu einem Plasma erregt wird,
das zu einem Plasma erregte Prozessgas veranlasst wird, aus der oberen Kammer (12) in die untere Kammer (13) zu strömen, und Ionen (A) in dem Prozessgas durch das Ionenabzugsmittel (14; 50; 12c; 13b) abgezogen werden, während das Prozessgas aus der oberen Kammer (12) in die untere Kammer (13) strömt, und
das Plasmaätzverfahren **dadurch gekennzeichnet ist, dass**: der Teil des Prozessgases, der nicht zu einem Plasma erregt wurde und aus der oberen Kammer (12) in die untere Kammer (13) strömt, durch das zweite Plasmaerzeugungsmittel (29) in der unteren Kammer (13) so zu einem Plasma erregt wird, dass die Radikalen (B)-Dichte und die Ionen (A)-Dichte des Plasmas jeweils über die gesamte Oberseite des Substrats (K) hinweg gleichmäßig sind,
das Plasma in der unteren Kammer (13) durch das Prozessgas, das aus der oberen Kammer (12) in die untere Kammer (13) strömt, und durch die Erregung zu Plasma durch das zweite Plasmaerzeugungsmittel (29) so justiert wird, dass die Ionen (A)-Dichte des Plasmas über die gesamte Oberseite des Substrats (K) hinweg gleichmäßig ist und die Radikalen (B)-Dichte des Plasmas in einem mittigen Abschnitt des Substrats (K) höher wird als an einem Umfangsrandabschnitt des Substrats (K), und
das Substrat (K) durch das justierte Plasma geätzt wird.

2. Plasmaätzverfahren nach Anspruch 1, **dadurch gekennzeichnet, dass** das Ionenabzugsmittel (14) durch ein geerdetes plattenförmiges Element (14) ausgebildet ist, das mehrere Durchgangslöcher (14a) aufweist, die von seiner Oberseite zu seiner Unterseite hindurch verlaufen, das plattenförmiges Element (14) in einem unteren Teil der oberen Kammer (12) oder in einem oberen Teil der unteren Kammer (13) in einer solchen Weise angeordnet ist, dass es den Innenraum der Verarbeitungskammer (11) unterteilt, und
Ionen (A) in dem Prozessgas, das aus der oberen Kammer (12) in die untere Kammer (13) strömt, durch das Ionenabzugsmittel (14) abgezogen werden.

3. Plasmaätzverfahren nach Anspruch 1, **dadurch gekennzeichnet, dass**
mindestens entweder an einem unteren Teil der oberen Kammer (12) oder an einem oberen Teil der unteren Kammer (13) ein geerdeter Abschnitt ausgebildet ist, und
das Ionenabzugsmittel (50) eine Spule (51) hat, die am Außenumfangsrand der oberen Kammer (12) in einer solchen Weise angeordnet ist, dass sie um die obere Kammer (12) und eine Gleichstromversorgungseinheit (52) zum Leiten eines Gleichstroms durch die Spule (51) herum gewunden ist, und dafür ausgebildet ist, Ionen (A) in dem Prozessgas, das durch das erste Plasmaerzeugungsmittel (26) zu dem Plasma erregt wurde, mittels eines Magnetfeldes, das durch die Spule (51) erzeugt wird, durch die ein Gleichstrom fließt, in Richtung der Innenseite des geerdeten Abschnitts der Verarbeitungskammer (11) zu bewegen und sie in Kontakt mit der Innenseite des geerdeten Abschnitts der Verarbeitungskammer (11) zu bringen, um dadurch die Ionen (A) aus dem Prozessgas abzuziehen.

4. Plasmaätzverfahren nach Anspruch 1, **dadurch gekennzeichnet, dass**
ein unterer Abschnitt der oberen Kammer (12), der einer Region unter einer plasmaerzeugenden Region entspricht, in der das Prozessgas durch das erste Plasmaerzeugungsmittel (26) im Innenraum der oberen Kammer (12) zu dem Plasma erregt wird, oder eine ringförmige obere Platte der unteren Kammer (13), mit der die obere Kammer (12) verbunden ist, aus einem geerdeten Metall besteht und der untere Abschnitt der oberen Kammer (12) oder die obere Platte der unteren Kammer (13), die aus dem geerdeten Metall besteht, so angeordnet ist, dass sie im Innenraum der Verarbeitungskammer (11) frei liegt, und
das Ionen (A)-Abzugsmittel den geerdeten unteren Abschnitt der oberen Kammer (12) oder die geerdete obere Platte der unteren Kammer (13) umfasst und dafür ausgebildet ist, die Ionen in dem Prozessgas abzuziehen, indem die Ionen mit dem geerdeten unteren Abschnitt der oberen Kammer (12) oder der geerdeten oberen Platte der unteren Kammer (13) in Kontakt gebracht werden.

## Revendications

1. Procédé de gravure au plasma consistant à graver au plasma un substrat (K) en utilisant un appareil de gravure au plasma (1 ; 2 ; 3 ; 4), l'appareil de gravure au plasma (1 ; 2 ; 3 ; 4) comportant :
- une chambre de traitement (11) comprenant une chambre supérieure (12) laquelle est configurée par un élément en forme de conteneur cylindrique ayant une ouverture au fond de celui-ci et une chambre inférieure (13) laquelle est configurée par un élément en forme de conteneur cylindrique ayant une ouverture au-dessus de celui-ci, les chambres supérieure et inférieure (12, 13) étant disposées pour être verticalement alignées et ayant des espaces intérieurs respectifs communiquant entre eux, la chambre supérieure (12) étant formée pour avoir un diamètre extérieur inférieur au diamètre extérieur de la chambre inférieure (13) et étant prévue au niveau d'une partie centrale de la surface supérieure de la chambre inférieure (13) ;
- une platine (16) qui est disposée dans la chambre inférieure (13) et sur laquelle le substrat (K) est placé ;
- des moyens d'alimentation en gaz (20) pour alimenter en gaz de traitement comprenant un gaz de gravure au moins dans la chambre supérieure (12),
- des premiers moyens de génération de plasma (26) comprenant une bobine (27) qui sont prévus sur la périphérie extérieure de la chambre supérieure (12) et auxquels une puissance RF est délivrée, et excitant le gaz de traitement délivré à l'intérieur de la chambre supérieure (12) dans un plasma ;
- des seconds moyens de génération de plasma (29) comprenant une bobine (30) qui sont prévus sur la périphérie extérieure de la chambre inférieure (13) et auxquels une puissance RF est délivrée, et excitant le gaz de traitement circulant depuis la chambre supérieure (12) à l'intérieur de la chambre inférieure (13) dans un plasma ;
- des moyens d'échappement (35) pour évacuer le gaz à l'intérieur de la chambre de traitement (11) afin de réduire la pression à l'intérieur de la chambre de traitement (11) ;
- des moyens d'alimentation de puissance (32) pour fournir une puissance RF à la platine (16) ; et
- des moyens d'élimination d'ions (14 ; 50 ; 12c ; 13b) pour éliminer des ions (A) du gaz de traitement excité dans le plasma par les premiers moyens de génération de plasma (26) et circulant depuis la chambre supérieure (12) dans la chambre inférieure (13),
dans lequel dans le procédé de gravure au plasma,
le gaz de traitement fourni dans la chambre supérieure (12) est excité dans un plasma par les premiers moyens de génération de plasma (26),
le gaz de traitement excité dans le plasma est amené à circuler depuis la chambre supérieure (12) dans la chambre inférieure (13) et des ions (A) dans le gaz de traitement sont éliminés par les moyens d'élimination d'ions (14, 50 ; 12c ; 13b) alors que le gaz de traitement circule depuis la chambre supérieure (12) dans la chambre inférieure (13), et
le procédé de gravure au plasma est **caractérisé en ce que** :
la partie du gaz de traitement, laquelle n'a pas été excitée dans un plasma et circule depuis la chambre supérieure (12) dans la chambre inférieure (13), est excitée dans un plasma par les seconds moyens de génération de plasma (29) dans la chambre inférieure (13) de sorte que chacune d'une densité extrême (B) et d'une densité d'ions (A) du plasma est uniforme sur la surface supérieure entière du substrat (K),
le plasma dans la chambre inférieure (13) est ajusté par le gaz de traitement circulant depuis la chambre supérieure (12) dans la chambre inférieure (13) et par l'excitation dans le plasma par les seconds moyens de génération de plasma (29) de sorte que la densité d'ions (A) du plasma est uniforme sur la surface supérieure entière du substrat (K) et la densité extrême (B) du plasma au niveau d'une partie centrale du substrat (K) devient supérieure à celle d'une partie périphérique du substrat (K), et
le substrat (K) est gravé par le plasma ajusté.

2. Procédé de gravure au plasma selon la revendication 1, **caractérisé en ce que** les moyens d'élimination d'ions (14) sont configurés par un élément en forme de plaque mis à la terre (14) ayant une pluralité de trous traversants (14a) pénétrant depuis la surface supérieure dans la surface inférieure de celui-ci,
l'élément en forme de plaque (14) est disposé dans une partie inférieure de la chambre supérieure (12) ou dans une partie supérieure de la chambre inférieure (13) de manière à ce qu'il divise l'espace intérieur de la chambre de traitement (11), et
des ions (A) dans le gaz de traitement circulant depuis la chambre supérieure (12) dans la chambre inférieure (13) sont éliminés par les moyens d'élimination d'ions (14).

3. Procédé de gravure au plasma selon la revendication 1, **caractérisé en ce que**
au moins soit une partie inférieure de la chambre supérieure (12) soit une partie supérieure de la chambre inférieure (13) a une partie mise à la terre formée sur celle-ci, et
les moyens d'élimination d'ions (50) ont une bobine (51) qui est disposée sur la périphérie extérieure de la chambre supérieure (12) de manière à ce qu'elle s'enroule autour de la chambre supérieure (12) et une unité d'alimentation de puissance en courant continu DC (52) destinée à faire passer un courant continu à travers la bobine (51), et sont configurés pour éliminer des ions (A) dans le gaz de traitement excité dans le plasma par les premiers moyens de génération de plasma (26) en direction de la surface intérieure de la partie mise à la terre de la chambre de traitement (11) par l'intermédiaire d'un champ magnétique généré par la bobine (51) à travers laquelle un courant continu est passé et les amène en contact avec la surface intérieure de la partie mise à la terre de la chambre de traitement (11) de manière à éliminer les ions (A) du gaz de traitement.

4. Procédé de gravure au plasma selon la revendication 1, **caractérisé en ce que**
une partie inférieure de la chambre supérieure (12) correspondant à une région au-dessous d'une région de génération de plasma dans laquelle le gaz de traitement est excité dans le plasma par les premiers moyens de génération de plasma (26) dans l'espace intérieur de la chambre supérieure (12) ou une plaque supérieure annulaire de la chambre inférieure (13) à laquelle la chambre supérieure (12) est reliée est constituée d'un métal mis à la terre et la partie inférieure de la chambre supérieure (12) ou la plaque supérieure de la chambre inférieure (13) constituée du métal mis à la terre est prévue pour être exposée dans l'espace intérieur de la chambre de traitement (11), et
les moyens d'élimination d'ions (A) comprennent la partie inférieure mise à la terre de la chambre supérieure (12) ou la plaque supérieure mise à la terre de la chambre inférieure (13), et sont configurés pour éliminer les ions dans le gaz de traitement en amenant les ions en contact avec la partie inférieure mise à la terre de la chambre supérieure (12) ou la plaque supérieure mise à la terre de la chambre inférieure (13).
